# EUROPÄISCHE PATENTSCHRIFT

(11) **EP 2 309 282 B1**
(45) Veröffentlichungstag und Bekanntmachung des Hinweises auf die Patenterteilung: **11.12.2019**
(21) Anmeldenummer: 10008173.6
(22) Anmeldetag: 05.08.2010
(51) Int. Cl.: G01R 31/42, H02P 7/00, G01R 31/34, H02P 21/13, H02P 29/024

(54) **Verfahren zur Fehlererkennung bei der Ansteuerung eines Drehfeldmotors**
Method for detecting faults when controlling a rotating field motor
Procédé de détection des fautes lors de la commande d'un moteur à champ rotatif

(30) Priorität: 11.08.2009 DE 102009036919
(43) Veröffentlichungstag der Anmeldung: 13.04.2011
(73) Patentinhaber: Diehl AKO Stiftung & Co. KG, 88239 Wangen (DE)
(72) Erfinder: Olarescu, Nicola-Valeriu, 88239 Wangen (DE); Weinmann, Martin, 88339 Bad Waldsee (DE)
(74) Vertreter: Diehl Patentabteilung

(56) Entgegenhaltungen:
- WO-A1-2005/081005
- US-A- 5 559 419
- US-A1- 2007 229 018
- BRIZ F ET AL: "Online stator winding fault diagnosis in inverter-fed ac machines using high-frequency signal injection", IEEE TRANSACTIONS ON INDUSTRY APPLICATIONS, IEEE SERVICE CENTER, PISCATAWAY, NJ, US, Bd. 39, Nr. 4, 1. Juli 2003 (2003-07-01), Seiten 1109-1117, XP011098905, ISSN: 0093-9994, DOI: 10.1109/TIA.2003.813746

## Beschreibung

Die Erfindung betrifft ein Verfahren zur Fehlererkennung bei der Ansteuerung eines Drehfeldmotors mittels eines Frequenzumrichters, wobei in einem Ruhezustand der Frequenzumrichter die Phasenspannungen des Drehfeldmotors steuert und die Phasenströme des Drehfeldmotors gemessen werden.

Ein solches Verfahren eignet sich für eine Fehlererkennung in einem umrichtergespeisten Antrieb für ein durch einen Drehfeldmotor betriebenes Gerät. Insbesondere eignet sich das Verfahren zur Fehlererkennung bei der Ansteuerung eines Drehfeldmotors in einem Haushaltsgerät, wie z.B. in einer Waschmaschine, in einer Zentrifuge oder in einer Küchenmaschine, oder auch in einer Werkzeugmaschine. Unter einem Drehfeldmotor wird dabei z.B. ein permanent erregter elektrischer Synchronmotor, ein elektrischer Reluktanzmotor oder ein elektrischer Asynchronmotor verstanden.

Bei einem Drehfeldmotor werden mittels eines Frequenzumrichters die Motorphasen mit variablen Phasenspannungen beaufschlagt, so dass sich über die entsprechenden Motorwicklungen im Motor ein rotierendes Magnetfeld ergibt. Je nach Motorenausführung rotiert in diesem magnetischen Drehfeld der Rotor synchron oder asynchron.

Kommt es in dem Frequenzumrichter, in den Motorphasen oder in den Motorwicklungen zu einer Unterbrechung oder einem Kurzschluss, so kann dies im Betrieb des Motors zur thermischen Überlastung einer Motorwicklung führen, wodurch gegebenenfalls die Gefahr einer Entzündung des Motors besteht. Das rechtzeitige Erkennen derartiger Fehler im Antriebssystem eines Drehfeldmotors ist daher äußerst wünschenswert.

Ein Verfahren zur Fehlererkennung der eingangs genannten Art ist beispielsweise aus der EP 0 848 492 A1 bekannt. Dort wird in einem antriebslosen Zustand der Drehfeldmotor mit bestimmten Spannungsmustern betrieben. Zur Diagnose von Motorabnormalitäten und somit von Fehlern im Antriebssystem werden die Stromantworten beurteilt. Falls die Stromantwort eine abnormale Spitze oder Wellenform aufweist, wird auf einen Kurzschluss in den Motorphasen bzw. Zuleitungen oder in den Motorwicklungen geschlossen.

In der DE 102 36 377 A1 wird ein Verfahren zur Fehlererkennung bei einer Antriebseinrichtung mit einem Drehfeldmotor vorgeschlagen, wobei zur Fehlererkennung die Phasenströme zu einem gegebenen Zeitpunkt der jeweiligen Periode bei gleichzeitiger Variation der zugehörigen Phasenspannungen gemessen werden.

Aus BRIZ F ET AL, "Online stator winding fault diagnosis in inverter-fed ac machines using high-frequency signal injection", IEEE TRANSACTIONS ON IN-DUSTRY APPLICATIONS, IEEE SERVICE CENTER, PISCATAWAY, NJ, US, (20030701), vol. 39, no. 4, doi:10.1109/TIA.2003.813746 ist ein Verfahren zur Diagnose von Windungsfehlern eines Stators bekannt, bei dem ein hochfrequentes Trägersignal verwendet wird.

In WO 2005/081005 A1 ist ein Verfahren zur Erkennung einer an einem Umrichter angeschlossenen Mehrphasenmaschine und zur Anpassung des Umrichters an die angeschlossene Maschine vor einem aktiven Produktivbetrieb offenbart Dabei wird zumindest ein erstes und ein zweites Testsignals von dem Umrichter auf zumindest eine der mehreren elektrischen Phasen der angeschlossenen Maschine aufgeschaltet.

US 5,559,419 zeigt ein Verfahren zur Abschätzung eines Flusses einer Induktionsmaschine.

Es ist eine Aufgabe der Erfindung, ein verbessertes Verfahren zur Fehlererkennung bei der Ansteuerung eines Drehfeldmotors zur Verfügung zu stellen.

Diese Aufgabe wird für ein Verfahren der eingangs genannten Art erfindungsgemäß dadurch gelöst, dass im Ruhezustand des Drehfeldmotors die Phasenströme oder hiervon abgeleitete Stromgrößen auf eine vorgegebene Sollstromgröße geregelt werden, dass der Frequenzumrichter zur Ausgabe einer Störspannungsgröße für die Phasenspannungen gesteuert wird, dass die Antwort der Regelung auf die Störspannungsgröße beobachtet wird und dass aus der Antwort der Regelung auf einen Fehler des Frequenzumrichters und/oder der Phasen des Drehfeldmotors geschlossen wird.

Die Erfindung geht dabei von der Überlegung aus, dass bei einer Regelung auf die Phasenströme bewusst eingebrachte Störspannungen zu einer Antwort der Regelung führen, da derartige Störspannungen natürlicherweise zu gewissen zusätzlichen Phasenströmen führen. Bei einem intakten Antriebssystem wird die Regelantwort eine entsprechende Gegenspannung sein, mit der die aufgeschaltete Störspannung kompensiert wird. Wird die Regelung beispielsweise in einem Bezugssystem der Motorphasen betrachtet, so würde eine einer Phase aufgeschaltete Störspannung als Regelantwort zur Ausgabe einer entsprechenden Gegenspannung in dieser Phase führen. Der infolge der Störspannung fließende Phasenstrom wird durch die vom Regler ausgegebene Gegenspannung kompensiert.

Liegt eine Unterbrechung oder ein Kurzschluss im Frequenzumrichter, in den Phasen oder in den Motorwicklungen vor, so wird die Regelantwort jedoch von dem zu erwartenden Wert abweichen. Die durch die Störspannungsgröße nun resultierenden Phasenströme weichen nämlich vom intakten Zustand entsprechend ab.

Die Erfindung ist nicht darauf eingeschränkt, die Phasenströme auf eine ganz bestimmte Sollstromgröße zu regeln oder eine ganz bestimmte Störspannungsgröße auszugeben. Vielmehr kann die Sollstromgröße oder die Störspannungsgröße grundsätzlich beliebig ausgewählt werden. Die Erfindung bietet dadurch den großen Vorteil, dass ohne Einschränkung hinsichtlich der Fehlererkennung zur Regelung sehr kleine Sollströme oder Sollströme gleich Null ausgewählt werden können, wodurch unerwünschte Rotorbewegungen, Geräusche und Verluste im Drehfeldmotor, sowie Leitungsverluste im Frequenzumrichter während der Fehlererkennung vermieden oder minimiert werden.

Hinsichtlich des Regelverfahrens für den Drehfeldmotor ist die Erfindung ebenfalls nicht eingeschränkt. Die Regelung kann grundsätzlich die im Bezugssystem der Motorphasen real zu messenden Phasenströme als Regelgröße betreffen. Ebenso gut kann es sich bei der Regelung aber auch um eine sogenannte feldorientierte Regelung handeln, wozu elektromagnetische Zustandsgrößen des Drehfeldmotors mittels eines mathematischen Modells in Raumzeigerdarstellung ermittelt werden, und wobei der Frequenzumrichter entsprechend der aus realen Größen ermittelten Raumzeigergrößen elektronisch angesteuert wird.

In letzterem Fall werden die Sollstromgröße und die Störspannungsgröße nicht in Form von expliziten Sollphasenströmen bzw. Störphasenspannungen vorgegeben, sondern jeweils als entsprechende Komponenten des jeweiligen Raumzeigers in der Regelung beachtet.

Bei der inzwischen häufig eingesetzten Regelung eines Drehfeldmotors mittels Raumzeigergrößen wird die Tatsache ausgenutzt, dass die elektromagnetischen Zustandsgrößen in einem Drehfeldmotor durch ihren Betrag und durch ihre Richtung in einer Ebene hinreichend beschrieben sind. In einem geeigneten zweidimensionalen Koordinatensystem lassen sich somit die elektromagnetischen Zustandsgrößen eines Drehfeldmotors jeweils durch einen so genannten Raumzeiger darstellen, der durch seine Länge (Betrag) und durch seine Lage (Winkel) beschrieben ist. Alternativ können zu seiner Beschreibung die entsprechenden Koordinaten auf den Achsen des Koordinatensystems herangezogen werden. Durch eine mathematische Transformation der den Drehfeldmotor beschreibenden Zustandsgrößen auf ein drehendes Koordinatensystem lässt sich dieser regelungstechnisch auf einen Gleichstrommotor zurückführen.

Grundsätzlich werden bei der Regelung eines Drehfeldmotors mittels Raumzeigergrößen zwei verschiedene Koordinatensysteme verwendet. Das statorfeste Koordinatensystem, dessen Achsen mit α und β bezeichnet werden, ist fest mit dem Stator des Drehfeldmotors verbunden und steht still. Die elektromagnetischen Raumzeigergrößen rotieren in diesem Koordinatensystem um den Ursprung mit der Frequenz des Drehfeldes. Die Phasenspannungen addieren sich beispielsweise vektoriell zu einem rotierenden Spannungsraumzeiger. Entsprechend dem Spannungsraumzeiger rotiert in dem α, β-Koordinatensystem der resultierende Raumzeiger der Statorflussverkettung.

Das feldorientierte Koordinatensystem, dessen Achsen mit d und q bezeichnet werden, rotiert mit dem Raumzeiger des Rotorflusses. Dieses Koordinatensystem ist insofern auf das Magnetfeld ausgerichtet, das den Rotor durchsetzt. Es rotiert mit der Frequenz der speisenden Spannung bzw. der Frequenz des Spannungsraumzeigers. In diesem Koordinatensystem sind die elektromagnetischen Größen des Drehfeldmotors Gleichgrößen, d.h. ihre Koordinaten weisen keinen sinusförmigen Verlauf auf. Der jeweilige Drehwinkel des rotierenden d, q-Koordinatensystems wird mit θ bezeichnet.

In einer bevorzugten Ausgestaltung der Erfindung wird dementsprechend der Drehfeldmotor mittels Raumzeigergrößen feldorientiert geregelt, wobei der Frequenzumrichter mittels eines Spannungsraumzeigers elektronisch angesteuert und als Regelgröße ein aus den Phasenströmen gebildeter Stromraumzeiger verwendet wird, wobei die Sollstromgröße als ein Sollstromraumzeiger vorgegeben wird, wobei als Störspannungsgröße ein Störspannungsraumzeiger dem Reglerausgang aufgeschaltet wird, und wobei als Antwort der von der Regelung ausgegebene Spannungsraumzeiger beobachtet wird.

Im Fall einer feldorientierten Regelung des Drehfeldmotors mittels Raumzeigergrößen kann dabei zur Fehlererkennung auf eine bereits implementierte Stromregelung zurückgegriffen werden. Da für die vorhandene Stromregelung im originären Antriebssystem ohnehin bereits die Phasenströme gemessen werden, ist zur Implementierung der Fehlererkennung kein zusätzlicher Aufwand in der Messeinrichtung erforderlich. Ein weiterer Vorteil der feldorientierten Regelung ist generell die Tatsache, dass weniger Komponenten zur Regelung benötigt werden, dennoch aber im Regelungssystem alle Motorphasen abgetastet werden.

Zur Fehlererkennung wird in einem Ruhezustand des Drehfeldmotors der Störspannungsraumzeiger dem Reglerausgang aufgeschaltet, so dass über den hierdurch angesteuerten Frequenzumrichter die entsprechenden Phasenspannungen generiert werden. Aus diesen resultieren gewisse Phasenströme, die gemessen und nach einer Transformation in den Regler als Iststromraumzeiger eingehen. Aus dem Vergleich zwischen Iststromraumzeiger und vorgegebenem Sollstromraumzeiger resultiert ein von der Regelung ausgegebener Spannungsraumzeiger, über welchen der Frequenzumrichter zur Ausgabe entsprechender Phasenspannungen zur Kompensation der verursachten Phasenströme angesteuert wird.

Bevorzugt werden mittels der Sollstromgröße die Phasenströme auf einen Wert von weniger als 1/10 der Nennströme des Drehfeldmotors geregelt. Dabei bezeichnen die Nennströme die im Normalbetrieb des Drehfeldmotors fließenden Ströme, auf die das Antriebssystem als solches generell ausgelegt ist. Durch eine derartige Begrenzung werden, wie bereits ausgeführt, Verluste im Frequenzumrichter sowie im Motor minimiert. Unerwünschte Rotorbewegungen und Geräusche werden vermieden. Besonders bevorzugt werden mittels der Sollstromgröße die Phasenströme auf einen Nullstrom geregelt.

In einer weiter bevorzugten Ausführung hinsichtlich der feldorientierten Regelung mittels Raumzeigergrößen wird der Störspannungsraumzeiger mehrfach mit verschiedenen Drehwinkeln aufgeschaltet und die jeweilige Antwort der Regelung beobachtet. Auf diese Weise werden die Motorphasen und die Schaltzustände des Frequenzumrichters gewissermaßen abgetastet. Dies erlaubt eine Lokalisierung der Fehlerquelle. Tritt beispielsweise bei einem spezifisch gewählten Winkel eine unerwartete Regelantwort auf, so kann der Fehler dem diesem Winkel zugeordneten Schaltzustand des Frequenzumrichters oder einer von diesem Schaltzustand versorgten Motorphase zugeordnet werden. Durch Beobachtung der Regelungsantwort bei verschiedenen Winkeln wird es somit möglich, einen festgestellten Fehler spezifisch einem Schaltelement des Frequenzumrichters oder einer spezifischen Motorphase zuzuordnen.

In einer bevorzugten Alternative hinsichtlich der feldorientierten Regelung mittels Raumzeigergrößen wird der Störspannungsraumzeiger kontinuierlich mit einer beliebigen Frequenz mindestens über eine Vollumdrehung aufgeschaltet und die jeweilige Antwort der Regelung beobachtet. Auf diese Weise werden die Motorphasen und die Schaltzustände des Frequenzumrichters gewissermaßen abgetastet. Dies erlaubt eine Lokalisierung der Fehlerquelle. Tritt beispielsweise bei einem spezifisch gewählten Winkel eine unerwartete Regelantwort auf, so kann der Fehler dem diesem Winkel zugeordneten Schaltzustand des Frequenzumrichters oder einer von diesem Schaltzustand versorgten Motorphase zugeordnet werden. Durch Beobachtung der Regelungsantwort bei verschiedenen Winkeln wird es somit möglich, einen festgestellten Fehler spezifisch einem Schaltelement des Frequenzumrichters oder einer spezifischen Motorphase zuzuordnen. Durch eine kontinuierliche Aufschaltung des Störspannungsraumzeigers können Fehler lückenlos erkannt werden. Eine weitere Verbesserung der Fehlererkennung wird erreicht, insbesondere bei einem permanenterregten elektrischen Synchronmotor, indem die kontinuierliche Aufschaltung des Störspannungsraumzeigers mit einer Aufschaltung mit verschiedenen Drehwinkeln kombiniert wird.

Weiter bevorzugt wird der Störspannungsraumzeiger mehrfach um jeweils denselben Winkelschritt versetzt über eine Vollumdrehung aufgeschaltet. Hierdurch wird eine weitere Präzisierung hinsichtlich der Fehlerlokalisierung möglich, da der gesamte Schalt- bzw. Phasenraum systematisch abgetastet wird.

Für einen dreiphasigen Drehfeldmotor wird in einer vorteilhaften Ausgestaltung der Störspannungsraumzeiger beispielweise sechsmal mit jeweils einem Winkelschritt von 60° versetzt über eine Vollumdrehung aufgeschaltet. Hintergrund dieser Ausgestaltung ist die Betrachtung der Schaltzustände eines zum Beschalten von drei Motorphasen vorgesehenen Frequenzumrichters. Üblicherweise weist ein solcher Frequenzumrichter jeweils drei Brückenzweige auf, die jeweils zwischen ein hohes und ein niedriges Potenzial geschaltet sind. In jedem dieser Brückenzweige sind jeweils zwei Schaltelemente eingesetzt, zwischen denen sich der Anschluss einer jeweiligen Motorphase befindet. Durch Schalten der jeweiligen Schaltelemente wird die jeweilige Motorphase entweder auf das hohe oder auf das niedrige Potenzial geschaltet. Es lässt sich dabei zeigen, dass sich für einen derartigen Frequenzumrichter insgesamt sechs aktive Schaltzustände ergeben. Die diesen Schaltzuständen entsprechenden Spannungsraumzeiger sind im Raumzeigermodell jeweils um 60° zueinander gedreht, wodurch der gesamte Raum aufgespannt wird. Die Erzeugung eines zwischen den aktiven Schaltzuständen liegenden Spannungsraumzeigers geschieht dadurch, dass die beiden benachbarten Schaltzustände unterschiedlich lange geschaltet werden. Mit anderen Worten wird der gewünschte Spannungsraumzeiger durch eine Pulsweitenmodulation erzeugt.

Es wird ersichtlich, dass mit jeweils um 60° versetzt erzeugte Störspannungsraumzeiger alle aktiven Schaltzustände, und somit alle Schaltelemente der einzelnen Brückenzweige des Frequenzumrichters abgetastet werden. Aus einer Betrachtung der gesamten Regelungsantwort gelingt es somit, das fehlerhafte Schaltelement des Frequenzumrichters zu lokalisieren. Andererseits sind von den jeweiligen Schaltzuständen auch jeweils spezifische Motorphasen betroffen. Somit wird es auch möglich, auf eine Unterbrechung oder auf einen Kurzschluss einer spezifischen Motorphase zu schließen.

Hinsichtlich der Fehlererkennung wird zweckmäßigerweise als Antwort die Größe der Komponenten des vom Regler ausgegebenen Spannungsraumzeigers oder die Größe der umgerechneten Phasenspannungen beobachtet. Bei intaktem Antriebssystem wird die Größe der Komponenten des ausgegebenen Spannungsraumzeigers in etwa der Größe der Komponenten des Störspannungsraumzeigers entsprechen. Gleiches gilt entsprechend für die umgerechneten Phasenspannungen und Störphasenspannungen. Ist ein entsprechendes Schaltelement des Frequenzumrichters oder eine der Motorphasen bzw. Motorwicklungen fehlerbehaftet, so wird die Regelungsantwort hiervon abweichen. Die Abweichung lässt sich leicht beobachten.

In einer Weiterbildung hiervon wird als Antwort das Verhältnis der Komponenten des ausgegebenen Spannungsraumzeigers und des Störspannungraumzeigers oder der umgerechneten entsprechenden Phasenspannungen beobachtet. Aus einem derart ermittelten Verhältniswert kann unmittelbar auf einen Fehler geschlossen und dieser lokalisiert werden.

In beiden Fällen kann für die jeweils betrachtete oder gebildete Größe ein Grenzwert vorgegeben werden. Wird dieser überschritten, so wird beispielsweise ein entsprechendes Warnsignal ausgegeben oder das Antriebssystem außer Betrieb gesetzt. Mit dem entsprechenden Warnsignal kann beispielsweise dem Benutzer eine Aufforderung zur Anforderung eines Wartungsdienstes ausgegeben werden.

Wird auf diese Weise beispielsweise eine unerwartete Abweichung zwischen der Störspannungsgröße und der Ausgangspannung des Stromreglers festgestellt, so kann auf eine zugeordnete Unterbrechung des Frequenzumrichters geschlossen werden, oder bei Detektion eines Überstroms auf einen Erdschluss oder auf ein kurzgeschlossenes Schaltelement des Frequenzumrichters geschlossen werden. Ein Überstrom tritt auf, bevor eine entsprechende unerwartete Abweichung festgestellt wird.

In einer weiter zweckmäßigen Ausgestaltung wird der Störspannungsraumzeiger mehrfach mit verschiedenem Drehwinkel aufgeschaltet und aus der Zuordnung der detektierten unerwarteten Abweichung zum Drehwinkel wird auf eine Unterbrechung geschlossen, oder aus der Zuordnung des detektierten Überstroms wird auf das konkrete kurzgeschlossene Schaltelement oder auf die konkrete Motorphase mit Erdschluss geschlossen.

Sofern das vorbeschriebene Verfahren unter Aufschaltung einer Störspannungsgröße zu keinen beobachtbaren Abweichungen in der Antwort der Regelung führt, werden in einer weiter bevorzugten Ausgestaltung die Phasenströme bei Anlauf des Drehfeldmotors beobachtet. Sofern bei Anlauf des Drehfeldmotors ein Überstrom festgestellt wird, kann auf einen Klemmenkurzschluss zwischen den Motorphasen geschlossen werden.

Ausführungsbeispiele der Erfindung werden anhand einer Zeichnung näher erläutert. Dabei zeigen:
- Fig. 1: schematisch zwei Varianten einer Ansteuerung eines Drehfeldmotors mit Messung der Phasenströme,
- Fig. 2: drei Varianten zur Erzeugung von Störspannungsraumzeigem,
- Fig. 3: ein Blockschaltbild zur Regelung eines Drehfeldmotors mittels Raumzeigergrößen,
- Fig. 4,5: im d,q-Bezugssystem sowie im Bezugssystem der Motorphasen den Verlauf der Phasenspannungen und Störspannungen bei einem intaktem Antriebssystem,
- Fig. 6,7: im d,q-Bezugssystem sowie im Bezugssystem der Motorphasen den Verlauf der Phasenspannungen und Störspannungen im Fall eines defekten sechsten Schaltelements des Frequenzumrichters,
- Fig. 8,9: Im d.q-Bezugssystem sowie im Bezugssystem der Motorphasen den Verlauf der Phasenspannungen und Störspannungen im Fall eines defekten fünften Schaltelements des Frequenzumrichters, und
- Fig. 10,11: im d,q-Bezugssystem sowie im Bezugssystem der Motorphasen den Verlauf der Phasenspannungen und Störspannungen im Fall einer Unterbrechung der dritten Motorphase.

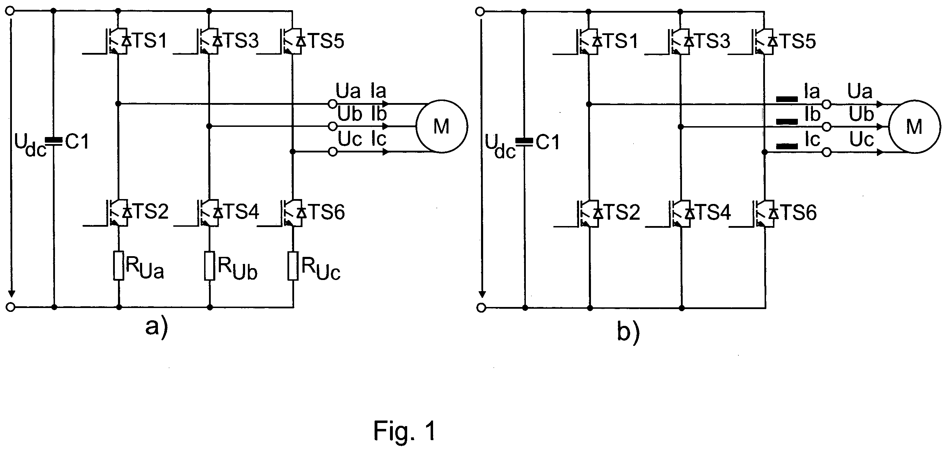

Die Fig.1a) und 1b) zeigen zwei Varianten für die Regelung eines Drehfeldmotors M mittels eines Frequenzumrichters, der entsprechend angesteuert die jeweils benötigten Phasenspannungen Uₐ, U_{b} und U_{c} ausgibt. In beiden Varianten wird jeweils auf die Phasenströme Iₐ. I_{b} und I_{c} geregelt. Hierzu werden gemäß Fig. 1a) die Phasenströme Iₐ, I_{b} und I_{c} über die Widerstände R_{Ua}, R_{Ub} und R_{Uc} in den zugehörigen Brückenzweigen des Frequenzumrichters gemessen. Nach Fig. 1b) erfolgt die Messung der Phasenströme Iₐ, I_{b} und I_{c} direkt an den Motorphasen.

Der in den Fig. 1a) und 1b) dargestellte Frequenzumrichter umfasst jeweils drei Brückenzweige, die zwischen einem hohen Potenzial und einem niedrigen Potenzial eines Gleichspannungszwischenkreises eingeschaltet sind. Im Gleichspannungszwischenkreis ist ein entsprechender Pufferkondensator C1 vorgesehen. Die Gleichspannung U_{dc} ist eingezeichnet. Jeder Brückenzweig umfasst jeweils zwei Schaltelemente. Die insgesamt sechs Schaltelemente in den drei Brückenzweigen sind mit TS1 bis TS6 durchnummeriert. Die drei Motorphasen a, b, c sind jeweils zwischen den zwei Schaltelementen eines Brückenzweigs angeschlossen.

Die Schaltelemente TS1 bis TS6 sind beispielsweise jeweils als MOSFET (Metall Oxide Semiconductor Field-Effect Transistor) oder als IGBT (Insulated Gate Bipolar Transistor) ausgeführt. Durch entsprechendes Takten bzw. Schalten der einzelnen Schaltelemente TS1 bis TS6 des Frequenzumrichters können die jeweiligen Motorphasen abwechselnd mit dem hohen und dem niedrigen Potenzial des Gleichspannungszwischenkreises verbunden werden. Durch Pulsweitenmodulation, d.h. durch ein getaktetes Schalten der Schaltelemente mit variabler Schaltzeit, können den Motorphasen die zur Erzeugung des magnetischen Drehfelds im Stator notwendigen Phasenspannungen bzw. Phasenströme aufgeprägt werden.

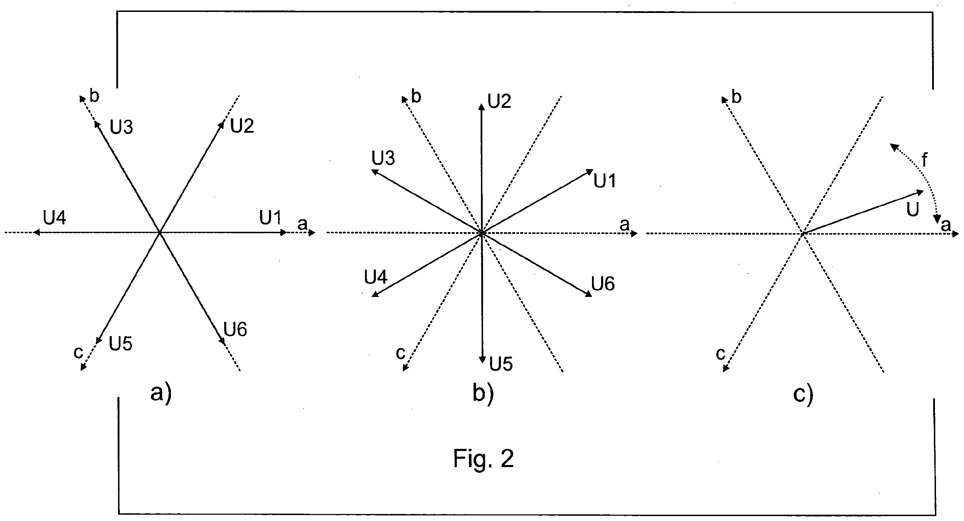

Aus den Fig. 2a), 2b) und 2c) werden die insgesamt sechs verschiedenen aktiven Schaltzustände des Frequenzumrichters ersichtlich. Die sechs aktiven Schaltzustände treten auf, wenn entweder ein oberes Schaltelement (TS1, TS3, TS5) und zwei untere Schaltelemente (TS2, TS4, TS6) oder zwei untere und ein oberes Schaltelement simultan auf Durchlass geschaltet sind. Die inaktiven Zustände treten auf, wenn entweder alle oberen oder alle unteren Schaltelemente durchgeschaltet sind.

In Raumzeigerdarstellung gemäß den Fig. 2a) und 2b) entsprechen den sechs aktiven Schaltzuständen des Frequenzumrichters sechs Spannungsraumzeiger, die um einen gemeinsamen Mittelpunkt jeweils um 60° verdreht angeordnet sind. Diese Spannungsraumzeiger oder Schaltzustände spannen als eine mögliche Basis den Raum in diesem Koordinatensystem auf.

Jeweils zwei um 180° gedrehte Schaltzustände entsprechen den in einer jeweiligen Motorphase auftretenden Maximalspannungen mit jeweils verschiedenen Vorzeichen. Entsprechend sind in den Fig. 2 diese den Raum aufspannenden Basen zusammengefasst und entsprechend den zugehörigen Motorphasen mit a, b und c bezeichnet. Liegt beispielsweise ein Spannungsraumzeiger auf der positiven a-Achse, so entspricht dies einem Schaltzustand, in dem das obere Schaltelement TS1 und die unteren Schaltelemente TS4 und TS6 jeweils durchgeschaltet sind. Ein Spannungsraumzeiger, der auf der negativen a-Achse liegt, entspricht einem Schaltzustand des Frequenzumrichters, wobei das Schaltelement TS2 und die Schaltelemente TS3 und TS5 jeweils durchgeschaltet sind. Gleiches gilt für die weiteren Basen oder Achsen b und c entsprechend.

Durch die Fig. 2a), 2b) und 2c) wird hinsichtlich der Erfindung verdeutlicht, wie insbesondere Störspannungen oder insbesondere ein Störspannungsraumzeiger zur Abtastung möglicher Fehlerquellen in den Motorphasen und/oder den Schaltelementen des Frequenzumrichters erzeugt werden. Nach Fig. 2a) werden insgesamt sechs Störspannungsraumzeiger U₁ bis U₆ entsprechend den originären Schaltzuständen des Frequenzumrichters erzeugt. Damit wird der dargestellte Raum jeweils in 60°-Schritten abgetastet. Entsprechend Fig. 2b) werden sechs Störspannungsraumzeiger nacheinander durch eine entsprechende Taktung von jeweils zwei Schaltzuständen des Frequenzumrichters erzeugt. Beispielsweise wird der Störspannungsraumzeiger U₁ durch eine Kombination des der Maximalspannung in der Motorphase a entsprechenden ersten Schaltzustand mit dem einer negativen Maximalspannung in der Motorphase c entsprechenden Schaltzustand erzeugt. Auch die gemäß Fig. 2b) erzeugten Störspannungsraumzeiger tasten den gesamten Raum mit äquidistanten Winkelschritten von jeweils 60° ab. Nach Fig. 2c) wird ein kontinuierlicher Störspannungsraumzeiger U mit einer beliebigen Frequenz f mindestens über eine Vollumdrehung erzeugt.

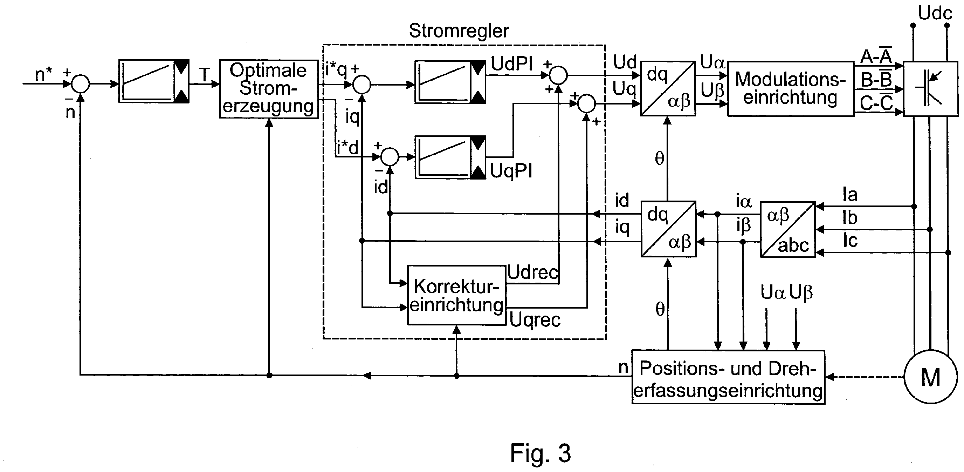

In Fig. 3 ist ein Blockdiagramm fûr eine Regelung eines Drehfeldmotors M mittels Raumzeigergrößen dargestellt. Man erkennt auf der rechten Seite dieser Darstellung die drei Motorphasen, die von einem Frequenzumrichter mit Spannungen beaufschlagt werden. Die Gleichspannung des Gleichspannungszwischenkreises des Frequenzumrichters Ist wiederum mit U_{dc} bezeichnet. An den Motorphasen des Drehfeldmotors M werden die Phasenströme Iₐ, I_{b} und I_{c} abgegriffen und der Regelung zugeführt. Es handelt sich hierbei um eine stromgeregelte Ansteuerung. Der Stromregler (current controller) ist markiert.

Ausgangspunkt der dargestellten feldorientierten Regelung sind die im d,q-Bezugssystem vorgegebenen Sollströme i*_{q} und i*_{d}. Dies sind die Komponenten des Iststromraumzeigers im betreffenden d.q-Bezugssystem. Mittels des Stromreglers wird der Sollstromraumzeiger mit den Komponenten i*_{q} und i*_{d} in einen entsprechenden Phasenspannungsraumzeiger mit den Komponenten U_{d} und U_{q} umgesetzt, der unter Betrachtung des Drehwinkels θ in das α,β-Bezugssystem umgewandelt und nach entsprechend mathematischer Umsetzung in einer Modulationseinrichtung (space vector modulation) zur Ansteuerung des Frequenzumrichters herangezogen wird.

Zur Regelung werden die abgegriffenen Phasenströme Iₐ, I_{b} und I_{c} aus dem Bezugssystem der Motorphasen in das α,β-Bezugssystem umgerechnet und weiter unter Betrachtung des Drehwinkels θ in einer Positions- und Dreherfassungseinrichtung (position and speed observer) in einen Iststromraumzeiger im d,q-Bezugssystem mit den Komponenten i_{d} und i_{q} umgerechnet. Der Iststromraumzeiger wird zur Regelung dem Sollstromraumzeiger aufgeschaltet. Über eine Korrektureinrichtung (voltage reference calculation) wird mittels eines vorgegebenen mathematischen Modells, abhängig vom Motortyp, der Drehzahl sowie weiterer Effekte der abhängig vom Sollstromraumzeiger ausgegebene Spannungsraumzeiger gegebenenfalls korrigiert.

Das Verfahren zur Fehlererkennung eines derart geregelten Drehfeldmotors wird ohne weitere Komponenten und insbesondere ohne weiteren zusätzlichen Messaufwand durchgeführt. Hierbei wird in einem Ruhezustand des Drehfeldmotors mittels der vorhandenen Korrektur-Einrichtung (voltage reference calculation) dem Reglerausgang, d.h. dem Phasenspannungsraumzeiger Ud, Uq ein Störspannungsraumzeiger U_{dref}, U_{qref} aufgeschaltet. Beispielhaft hierzu wird ein Sollstromraumzeiger i*_{q}, i*_{d} mit einem Wert von jeweils Null vorgegeben. Mit anderen Worten wird im Ruhezustand des Drehfeldmotors auf einen Sollstrom von Null geregelt.

Infolge des vorgegebenen Störspannungsraumzeigers U_{dref}, U_{qref} werden sich in den Motorphasen a, b und c Ströme einstellen, die der Regler durch die Ausgabe eines entsprechenden Phasenraumzeigers U_{d}. U_{q} kompensieren wird. In intaktem Zustand wird eine vorgegebene Störspannung U_{dref} durch eine Phasenspannung U_{d} mit entgegengesetztem Vorzeichen kompensiert werden, so dass in den entsprechenden Motorphasen keine Spannung auftreten wird. Weist der Frequenzumrichter ein defektes Schaltelement auf, oder liegt eine Unterbrechung oder ein Kurzschluss in einer der Motorphasen a, b, c vor, so sieht die Antwort der Regelung entsprechend anders aus. Die in den Motorphasen gemessenen Ströme werden sich gegenüber dem intakten Zustand unterscheiden.

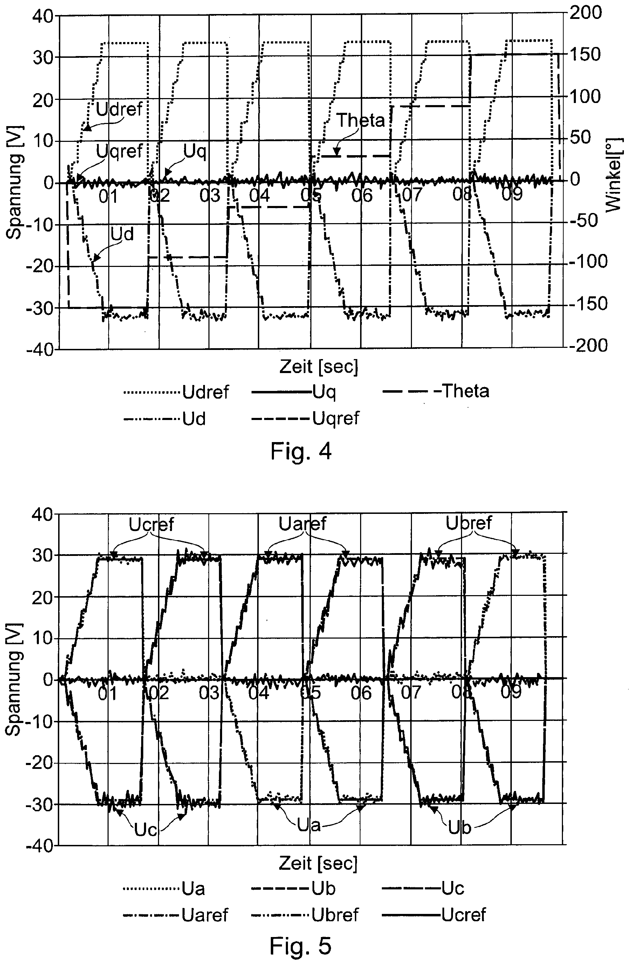

In den Fig. 4 bis 11 sind nun jeweils die Messergebnisse eines Verfahrens zur Fehlererkennung dargestellt, wobei für einen dreiphasigen Drehfeldmotor mit einer Steuerung nach Fig. 3 nacheinander jeweils sechs Störspannungsraumzeiger entsprechend Fig. 2b), dort bezeichnet mit U₁ bis U₆₁ dem Reglerausgang U_{d}, U_{q} in Fig. 3 aufgeschaltet werden. Die Störspannungsraumzeiger werden hierbei in der vorhandenen Regelung mittels der Korrektur-Einrichtung (voltage reference calculation) erzeugt. Die Fig. 4, 6, 8 und 10 zeigen jeweils den Verlauf der entsprechenden Spannungen und Störspannungen im d,q-Bezugssystem. Die Fig. 5, 7, 9 und 11 zeigen den Verlauf derselben Spannungen und Störspannungen im Bezugssystem der Motorphasen a,b und c.

In den Fig. 4, 6, 8 und 10 ist jeweils der zugehörige Drehwinkel des Rotors bzw. der dargestellten Raumzeiger, θ mit eingezeichnet. Dieser ist als Stufenfunktion erkennbar. Die zugehörigen Drehwinkel können an der rechten Ordinate abgelesen werden. Entsprechend Fig. 2b) werden zur Fehlererkennung die Störspannungsraumzeiger mit den Komponenten U_{dref} und U_{qref} mit Winkeln von -150°(U₄) bis +150° (U₃) erzeugt, und jeweils deren entsprechende Wirkung auf den Reglerausgang beobachtet. Hierzu wird der vom Regler ausgegebene Phasenspannungsraumzeiger mit den Komponenten U_{d} und U_{q} entsprechend Fig. 3 herangezogen.

In den Fig. 5, 7, 9 und 11 sind die entsprechenden Störspannungen und Phasenspannungen in das Bezugssystem der Motorphasen a, b und c umgerechnet. Es sind jeweils die den Motorphasen a, b, c zugeordneten Störspannungen U_{aref}, U_{bref} und U_{cref} sowie die Phasenspannungen Uₐ, U_{b} und U_{c} dargestellt.

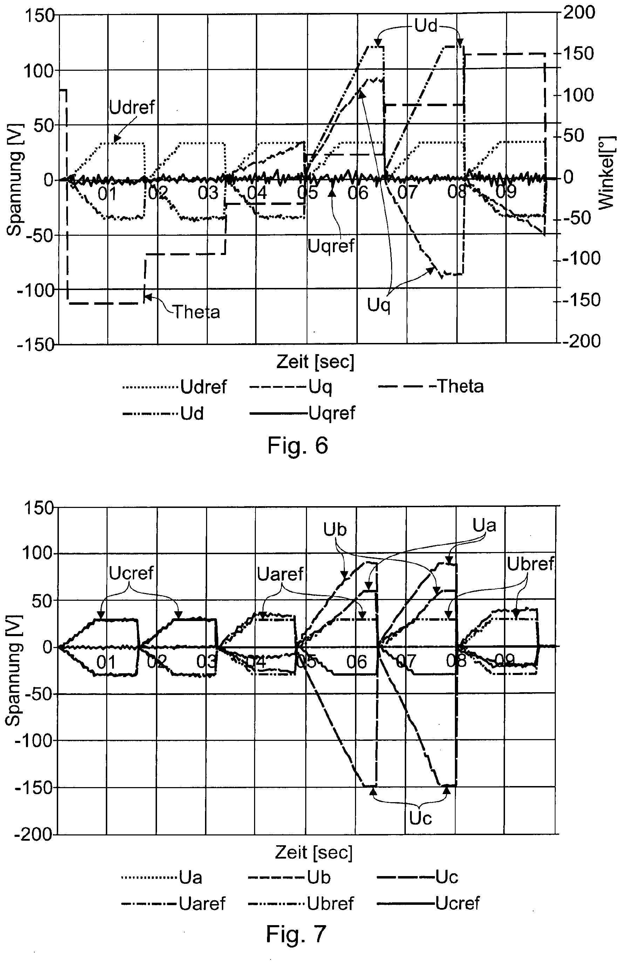

Die in den Fig. 6 bis 11 gezeigten Spannungsverläufe entsprechen einem jeweils mit unterschiedlichem Drehwinkel vorgegebenen Störspannungsraumzeiger mit den Komponenten U_{dref} = 33,4V und U_{qref} = 0. Der Sollstromraumzeiger wird mit beiden Komponenten i*_{d} und i*_{q} von jeweils 0 vorgegeben.

Der in den Fig. 4 und 5 dargestellte Verlauf der Spannungen entspricht einem intakten Antriebssystem. Für alle sechs durchlaufenen Störspannungsraumzeiger und den damit verbundenen Schaltzuständen des Frequenzumrichters wird eine entsprechend ausgegebene Störspannung U_{dref} durch eine Gegenspannung U_{d} kompensiert. Es ergibt sich in allen sechs Störspannungs-Situationen dasselbe symmetrische Bild bezüglich der Null-Linie. Da die Störspannung U_{qref} glelch 0 gewählt wurde, wird auch keine Gegenspannung U_{q} ausgegeben.

Entsprechendes gilt für Fig. 5, in der die Phasenspannungen bzw. die Störphasenspannungen in dem Bezugssystem der Motorphasen a, b, c dargestellt sind. Es findet abwechselnd eine Beaufschlagung der verschiedenen Motorphasen statt. Hierzu wird jeweils eine entsprechend geeignete Gegenspannung am Reglerausgang erzeugt.

Die Fig. 6 und 7 entsprechen der Situation, in denen gemäß Fig. 1 das untere Schaltelement TS6 defekt ist. Gemäß Fig. 6 ist zunächst in den Drehwinkeln - 150°, -90°, -30° sowie +150° zugeordneten Störspannungs-Situationen nichts Auffälliges gegenüber dem Intakten Verlauf zu erkennen. Die Störspannungen und die Phasenspannungen sind im Wesentlichen bezüglich der Null-Linie symmetrisch. Diese Symmetrie wird jedoch deutlich in den Störspannungs-Situationen gebrochen, in denen ein Störspannungsraumzeiger mit den Winkeln von +30° und +90° angelegt wird.

Betrachtet man Flg. 2b), so entsprechen die Winkel von +30° und von +90° den angelegten Störspannungsraumzeigern U₁ und U₂. Es wird ersichtlich, dass der Störspannungsraumzeiger U₁ durch eine Kombination eines positiven Schaltzustands "a" und eines negativen Schaltzustands "c" erzeugt ist, wodurch sich bereits entsprechend Fig. 1 auf einen Fehler in den Motorphasen a und c zugeordneten Brückenzweigen des Frequenzumrichters schließen lässt. Der Störspannungsraumzeiger U₂ wird entsprechend Fig. 2b) durch eine Linearkombination eines negativen Schaltzustands "c" und eines positiven Schaltzustands "b" erzeugt. Dies würde entsprechend Fig. 1 auf einen Fehler in den den Phasen b und c zugeordneten Brückenzweigen des Frequenzumrichters schließen lassen. Gemäß Fig. 6 tritt der Fehler jeweils nach Fig. 2b) in den negativen Schaltzuständen "c" auf. Nach Fig. 1 lässt sich nun darauf schließen, dass das Schaltelement TS6 defekt ist.

Dieselbe Information kann auch aus den Spannungsverläufen im Bezugssystem der Motorphasen entsprechend Fig. 7 entnommen werden.

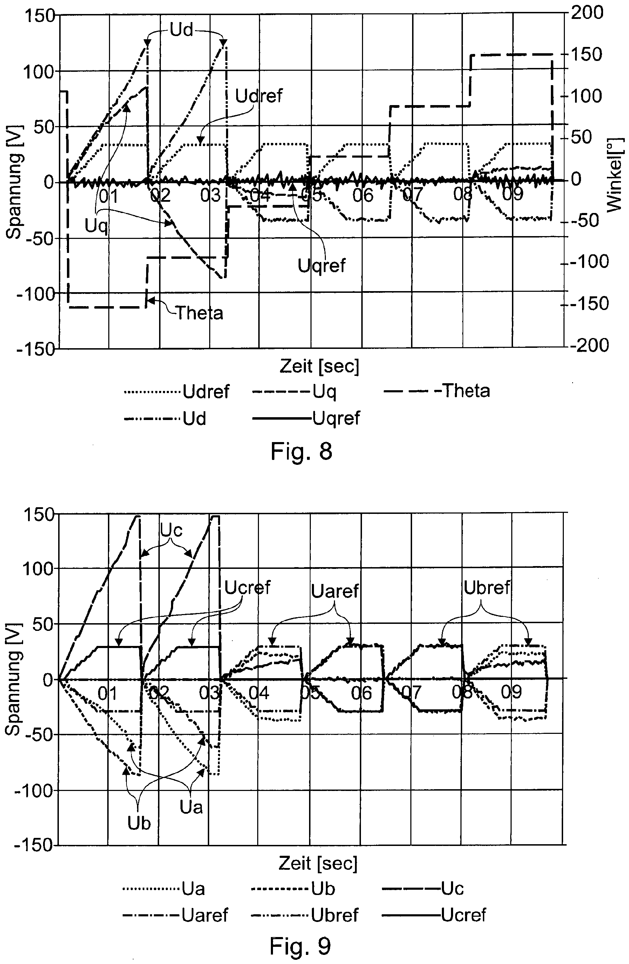

In den Fig. 8 und 9 entsprechen nun die dargestellten Spannungsverläufe dem Zustand, in dem entsprechend Fig. 1 das Schaltelement TS5 des Frequenzumrichters defekt ist.

Aus Fig. 8 wird sofort ersichtlich, dass der symmetrische Verlauf der Spannungen dort gebrochen ist, in denen der Störspannungsraumzeiger mit einem Winkel von -150° und von -90° angelegt wird. Nach Fig. 2 sind dazu die Störspannungsraumzeiger U₄ und U₅ angelegt. Entsprechend dem Vorgesagten lässt sich hieraus darauf schließen, dass ein Fehler bei der Schaltung der Motorphase c auf das hohe Potenzial entsprechend Fig. 1 auftritt. Aus dem Verlauf entsprechend Fig. 8 und ebenso aus Fig. 9 kann somit auf ein fehlerhaftes Schaltelement TS5 entsprechend Fig. 1 geschlossen werden.

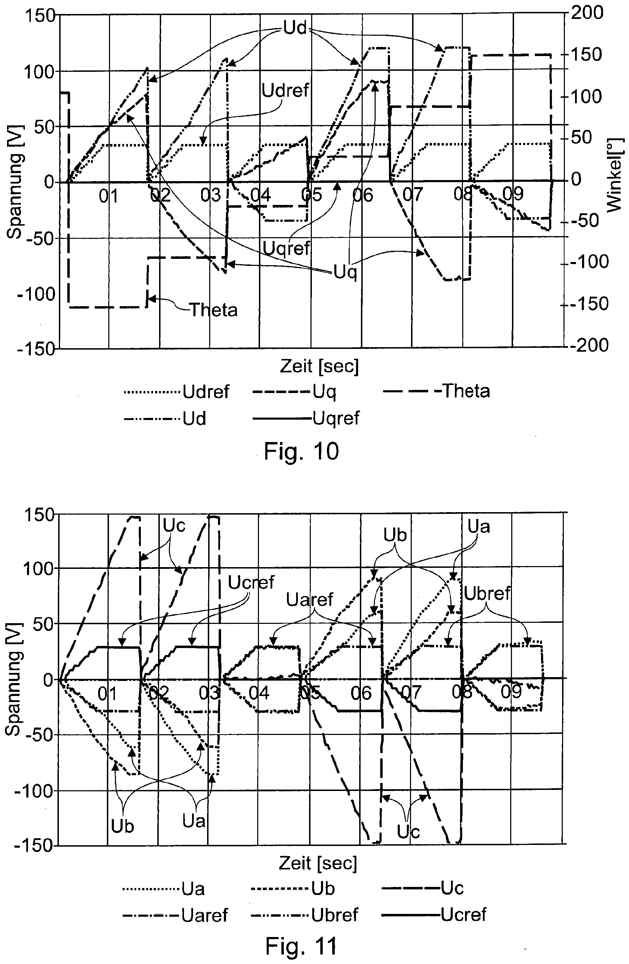

Der Verlauf der Spannungen entsprechend den Fig. 10 und 11 betrifft nun den Fall, in denen die Motorphase c eine Unterbrechung aufweist. Aus beiden Figuren wird sofort ersichtlich, dass die Symmetrie der Spannungsverläufe bezüglich der Null-Linie bei Anlegen der Störspannungsraumzeiger mit den Winkeln -150, -90°, +30° und +90° gebrochen ist. Wiederum unter Zuhilfenahme von Fig. 2 kann darauf geschlossen werden, dass dementsprechend die Störspannungsraumzeiger U₄, U₅, U₁ und U₂ betroffen sind. Es wird sofort ersichtlich, dass all diese Störspannungsraumzeiger durch eine Kombination mit einem Schaltzustand "c" gebildet sind. Der Fehler tritt hierbei unabhängig vom Vorzeichen des Schaltzustands "c" auf. Insofern kann unmittelbar darauf geschlossen werden, dass die Motorphase c unterbrochen ist.

## Patentansprüche

1. Verfahren zur Fehlererkennung bei der Ansteuerung eines Drehfeldmotors (M) mittels eines Frequenzumrichters, wobei in einem Ruhezustand der Frequenzumrichter die Phasenspannungen (Uₐ, U_{b}, U_{c}) des Drehfeldmotors (M) steuert und die Phasenströme (Iₐ, I_{b}, I_{c}) des Drehfeldmotors (M) gemessen werden,
**dadurch gekennzeichnet,**
**dass** weiter im Ruhezustand die Phasenströme (Iₐ, I_{b}, I_{c}) oder hiervon abgeleitete Stromgrößen auf eine vorgegebene Sollstromgröße (i*_{q}, i*_{d}) geregelt werden, dass der Frequenzumrichter zur Ausgabe einer Störspannungsgröße (U_{dref}, U_{qref}) für die Phasenspannungen (Uₐ, U_{b}, U_{c}) gesteuert wird, dass die Antwort der Regelung auf die Störspannungsgröße (U_{dref}, U_{qref}) beobachtet wird, und dass aus der Antwort der Regelung auf einen Fehler des Frequenzumrichters und/oder der Phasen des Drehfeldmotors (M) geschlossen wird.

2. Verfahren nach Anspruch 1,
**dadurch gekennzeichnet,**
**dass** der Drehfeldmotor (M) mittels Raumzeigergrößen feldorientiert geregelt wird, wobei der Frequenzumrichter mittels eines Spannungsraumzeigers elektronisch angesteuert und als Regelgröße ein aus den Phasenströmen (Iₐ, I_{b}, I_{c}) gebildeter Stromraumzeiger verwendet wird, wobei die Sollstromgröße (i*_{q}, i*_{d}) als ein Sollstromraumzeiger vorgegeben wird, wobei als Störspannungsgröße (U_{dref}, U_{qref}) ein Störspannungsraumzeiger dem Reglerausgang aufgeschaltet wird, und wobei als Antwort der von der Regelung ausgegebene Spannungsraumzeiger beobachtet wird.

3. Verfahren nach Anspruch 1 oder 2,
**dadurch gekennzeichnet,**
**dass** mittels der Sollstromgröße (i*_{q}, i*_{d}) die Phasenströme (Iₐ, I_{b}, I_{c}) auf einen Wert von weniger als ein Zehntel der Nennströme des Drehfeldmotors (M) geregelt werden.

4. Verfahren nach Anspruch 3,
**dadurch gekennzeichnet,**
**dass** mittels der Sollstromgröße (i*_{q}, i*_{d}) die Phasenströme (Iₐ, I_{b}, I_{c}) auf einen Nullstrom geregelt werden.

5. Verfahren nach einem der Ansprüche 2 bis 4,
**dadurch gekennzeichnet,**
**dass** der Störspannungsraumzeiger (U_{dref}, U_{qref}) mehrfach mit verschiedenen Drehwinkeln aufgeschaltet und die jeweilige Antwort der Regelung beobachtet wird.

6. Verfahren nach einem der Ansprüche 2 bis 5,
**dadurch gekennzeichnet,**
**dass** der Störspannungsraumzeiger (U_{dref}, U_{qref}) kontinuierlich mit einer beliebigen Frequenz (f) mindestens über eine Vollumdrehung aufgeschaltet und die jeweilige Antwort der Regelung beobachtet wird.

7. Verfahren nach Anspruch 5 oder 6,
**dadurch gekennzeichnet,**
**dass** der Störspannungsraumzeiger (U_{dref}, U_{qref}) mehrfach um jeweils denselben Winkelschritt versetzt über eine Vollumdrehung aufgeschaltet wird.

8. Verfahren nach Anspruch 7,
**dadurch gekennzeichnet,**
**dass** ein dreiphasiger Drehfeldmotor (M) geregelt wird, wobei der Störspannungsraumzeiger (U_{dref}, U_{qref}) sechsmal mit jeweils einem Winkelschritt von 60° versetzt über eine Vollumdrehung aufgeschaltet wird.

9. Verfahren nach einem der Ansprüche 2 bis 8,
**dadurch gekennzeichnet,**
**dass** als Antwort die Größe der Komponenten des vom Regler ausgegebenen Spannungsraumzeigers oder die Größe der umgerechneten Phasenspannungen (Uₐ, U_{b}, U_{c}) beobachtet wird.

10. Verfahren nach Anspruch 9,
**dadurch gekennzeichnet,**
**dass** als Antwort das Verhältnis der Komponenten des ausgegebenen Spannungsraumzeigers und des Störspannungsraumzeigers (U_{dref}, U_{qref}) oder der umgerechneten entsprechenden Phasenspannungen (Uₐ, U_{b}, U_{c}) beobachtet wird.

11. Verfahren nach Anspruch 9 oder 10,
**dadurch gekennzeichnet,**
**dass** bei Detektion einer entsprechenden unerwarteten Abweichung zwischen der Störspannungsgröße (U_{dref}, U_{qref}) und der Ausgangspannung des Stromreglers auf eine Unterbrechung des Frequenzumrichters geschlossen wird, oder bei Detektion eines Überstroms auf einen Erdschluss, oder auf ein kurzgeschlossenes Schaltelement (TS1, TS2, TS3, TS4, TS5, TS6) des Frequenzumrichters geschlossen wird.

12. Verfahren nach Anspruch 11,
**dadurch gekennzeichnet,**
**dass** der Störspannungsraumzeiger (U_{dref}, U_{qref}) mehrfach mit verschiedenem Drehwinkel aufgeschaltet wird, und dass aus der Zuordnung der detektierten unerwarteten Abweichung zum Drehwinkel auf eine Unterbrechung geschlossen wird, oder aus der Zuordnung des detektierten Überstroms auf das konkrete kurzgeschlossene Schaltelement oder auf die konkrete Motorphase mit Erdschluss geschlossen wird.

13. Verfahren nach einem der vorhergehenden Ansprüche,
**dadurch gekennzeichnet,**
**dass** bei einem fehlerfreien Ablauf die Phasenströme (Iₐ, I_{b}, I_{c}) bei Anlauf des Drehfeldmotors (M) beobachtet werden, und dass bei Feststellen eines Überstroms auf einen Klemmenkurzschluss zwischen den Motorphasen geschlossen wird.

## Claims

1. Method for fault identification when driving a polyphase motor (M) by means of a frequency converter, wherein, in a rest state, the frequency converter controls the phase voltages (Uₐ, U_{b}, U_{c}) of the polyphase motor (M) and the phase currents (Iₐ, I_{b}, I_{c}) of the polyphase motor (M) are measured,
**characterized**
**in that** then in the rest state, the phase currents (Iₐ, I_{b}, I_{c}) or current variables derived therefrom are adjusted by closed-loop control to a predetermined setpoint current variable (i*_{q}, i*_{d}), in that the frequency converter is controlled so as to output an interference voltage variable (U_{dref}, U_{qref}) for the phase voltages (Uₐ, U_{b}, U_{c}), in that the response of the closed-loop control to the interference voltage variable (U_{dref}, U_{qref}) is observed, and in that a conclusion is drawn from the response of the closed-loop control regarding a fault in the frequency converter and/or the phases of the polyphase motor (M).

2. Method according to Claim 1,
**characterized**
**in that** the polyphase motor (M) is subjected to field-oriented closed-loop control by means of space vector variables, wherein the frequency converter is driven electronically by means of a voltage space vector and a current space vector formed from the phase currents (Iₐ, I_{b}, I_{c}) is used as controlled variable, wherein the setpoint current variable (i*_{q}, i*_{d}) is predetermined as a setpoint current space vector, wherein an interference voltage space vector is fed forward to the controller output as interference voltage variable (U_{dref}, U_{qref}), and wherein the voltage space vector output by the closed-loop control system is observed as the response.

3. Method according to Claim 1 or 2,
**characterized**
**in that** the phase currents (Iₐ, I_{b}, I_{c}) are adjusted by closed-loop control to a value of less than a tenth of the rated currents of the polyphase motor (M) by means of the setpoint current variable (i*_{q}, i*_{d}).

4. Method according to Claim 3,
**characterized**
**in that** the phase currents (Iₐ, I_{b}, I_{c}) are adjusted by closed-loop control to a zero current by means of the setpoint current variable (i*_{q}, i*_{d}).

5. Method according to one of Claims 2 to 4,
**characterized**
**in that** the interference voltage space vector (U_{dref}, U_{qref}) is fed forward a plurality of times with different rotary angles, and the respective response of the closed-loop control is observed.

6. Method according to one of Claims 2 to 5,
**characterized**
**in that** the interference voltage space vector (U_{dref}, U_{qref}) is continuously fed forward with any desired frequency (f) at least over a full revolution, and the respective response of the closed-loop control is observed.

7. Method according to Claim 5 or 6,
**characterized**
**in that** the interference voltage space vector (U_{dref}, U_{qref}) is fed forward a plurality of times, shifted through in each case the same angular increment, over a full revolution.

8. Method according to Claim 7,
**characterized**
**in that** a three-phase polyphase motor (M) is subjected to closed-loop control, wherein the interference voltage space vector (U_{dref}, U_{qref}) is fed forward six times, shifted with in each case an angular increment of 60°, over a full revolution.

9. Method according to one of Claims 2 to 8,
**characterized**
**in that** the variable of the components of the voltage space vector output by the controller or the variable of the converted phase voltages (Uₐ, U_{b}, U_{c}) is observed as the response.

10. Method according to Claim 9,
**characterized**
**in that** the ratio of the components of the output voltage space vector and of the interference voltage space vector (U_{dref}, U_{qref}) or of the converted corresponding phase voltages (Uₐ, U_{b}, U_{c}) is observed as the response.

11. Method according to Claim 9 or 10,
**characterized**
**in that**, in the event of a corresponding unexpected discrepancy between the interference voltage variable (U_{dref}, U_{qref}) and the output voltage of the current controller being detected, it is concluded that there has been an interruption of the frequency converter, or in the event that an excess current is detected, it is concluded that there is an earth fault or a short-circuited switching element (TS1, TS2, TS3, TS4, TS5, TS6) of the frequency converter.

12. Method according to Claim 11,
**characterized**
**in that** the interference voltage space vector (U_{dref}, U_{qref}) is fed forward a plurality of times with a different rotary angle, and in that, from the assignment of the detected unexpected discrepancy to the rotary angle, it is concluded that there has been an interruption, or, from the assignment of the detected excess current, it is concluded that there is the specific short-circuited switching element or the specific motor phase with a ground fault.

13. Method according to one of the preceding claims,
**characterized**
**in that**, in the event of fault-free running, the phase currents (Iₐ, I_{b}, I_{c}) are observed during run-up of the polyphase motor (M), and in that, in the event of an excess current being established, it is concluded that there is a terminal short circuit between the motor phases.

## Revendications

1. Procédé de détection de défauts lors de la commande d'un moteur à champ tournant (M) au moyen d'un convertisseur de fréquence, dans lequel, à l'état de repos du convertisseur de fréquence, les tensions de phase (Uₐ, U_{b}, U_{c}) du moteur à champ tournant (M) sont commandées et les courants de phase (Iₐ, I_{b}, I_{c}) du moteur à champ tournant (M) sont mesurés,
**caractérisé en ce qu'**à l'état de repos, les courants de phase (Iₐ, I_{b}, I_{c}) ou des grandeurs de courant qui en sont dérivées sont en outre régulés à une grandeur de courant de consigne (i*_{q}, i*_{d}) prédéterminée, **en ce que** le convertisseur de fréquence est commandé pour délivrer en sortie une grandeur de tension de perturbation (U_{dref}, U_{qref}) pour les tensions de phase (Uₐ, U_{b}, U_{c}), **en ce que** la réponse de la régulation à la grandeur de tension de perturbation (U_{dref}, U_{qref}) est observée et **en ce qu'**il est conclu à partir de la réponse de la régulation qu'une erreur du convertisseur de fréquence et/ou des phases du moteur tournant (M) se produit.

2. Procédé selon la revendication 1,
**caractérisé en ce que** le moteur à champ tournant (M) est régulé d'une manière orientée champ au moyen de grandeurs de vecteur spatial, dans lequel le convertisseur de fréquence est commandé électroniquement au moyen d'un vecteur spatial de tension et **en ce qu'**un vecteur spatial de courant formé à partir des courants de phase (Iₐ, I_{b}, I_{c}) est utilisé en tant que grandeur régulée, dans lequel la grandeur de courant de consigne (i*_{q}, i*_{d}) est prédéterminée en tant que vecteur spatial de courant de consigne, dans lequel un vecteur spatial de tension de perturbation est appliqué à la sortie du régulateur en tant que grandeur de tension de perturbation (U_{dref}, U_{qref}), et dans lequel le vecteur spatial de tension délivré en sortie est observé en tant que réponse de la régulation.

3. Procédé selon la revendication 1 ou 2,
**caractérisé en ce que** les courants de phase (Iₐ, I_{b}, I_{c}) sont régulés à une valeur inférieure à un dixième des courants nominaux du moteur à champ tournant (M) au moyen des grandeurs de courant de consigne (i*_{q}, i*_{d}).

4. Procédé selon la revendication 3,
**caractérisé en ce que** les courants de phase (Iₐ, I_{b}, I_{c}) sont régulés à un courant nul au moyen de la grandeur de courant de consigne (i*_{q}, i*_{d}).

5. Procédé selon l'une des revendications 2 à 4,
**caractérisé en ce que** le vecteur spatial de tension de perturbation (U_{dref}, U_{qref}) est appliqué plusieurs fois avec différents angles de rotation et **en ce que** la réponse respective de la régulation est observée.

6. Procédé selon l'une des revendications 2 à 5,
**caractérisé en ce que** le vecteur spatial de tension de perturbation (U_{dref}, U_{qref}) est appliqué en continu avec une fréquence arbitraire (f) au moins sur un tour complet et **en ce que** la réponse respective de la régulation est observée.

7. Procédé selon la revendication 5 ou 6,
**caractérisé en ce que** le vecteur spatial de tension de perturbation (U_{dref}, U_{qref}) est appliqué plusieurs fois selon le même pas angulaire sur un tour complet.

8. Procédé selon la revendication 7,
**caractérisé en ce qu'**un moteur à champ tournant (M) est régulé, dans lequel le vecteur spatial de tension de perturbation (U_{dref}, U_{qref}) est appliqué six fois en étant décalé d'un pas angulaire respectif de 60° sur un tour complet.

9. Procédé selon l'une des revendications 2 à 8,
**caractérisé en ce que** la grandeur des composantes du vecteur spatial de tension délivré par le régulateur ou la grandeur des tensions de phase (Uₐ, U_{b}, U_{c}) converties est observée en tant que réponse.

10. Procédé selon la revendication 9,
**caractérisé en ce que** le rapport des composantes du vecteur spatial de tension de sortie et du vecteur spatial de tension de perturbation (U_{dref}, U_{qref}) ou les tensions de phase (Uₐ, U_{b}, U_{c}) converties correspondantes est observé en tant que réponse.

11. Procédé selon la revendication 9 ou 10,
**caractérisé en ce que**, lors de la détection d'un écart inattendu correspondant entre la grandeur de tension de perturbation (U_{dref}, U_{qref}) et la tension de sortie du régulateur de courant, il est conclu qu'il se produit une interruption du convertisseur de fréquence ou, lors de la détection d'une surintensité, qu'il se produit un défaut à la terre ou un court-circuit d'un élément de commutation (TS1, TS2, TS3, TS4, TS5, TS6) du convertisseur de fréquence.

12. Procédé selon la revendication 11,
**caractérisé en ce que** le vecteur spatial de tension de perturbation (U_{dref}, U_{qref}) est appliqué plusieurs fois selon un angle de rotation différent, et **en ce qu'**il est conclu à partir de l'association entre l'écart imprévu détecté et l'angle de rotation qu'il se produit une interruption, ou **en ce qu'**il est conclu à partir de l'association de la surintensité détectée, que le court-circuit de l'élément de commutation proprement dit est présent ou que la phase proprement dite du moteur présente le défaut à la terre.

13. Procédé selon l'une des revendications précédentes,
**caractérisé en ce que** les courants de phase (Iₐ, I_{b}, I_{c}) sont observés pendant le démarrage du moteur à champ tournant (M) lors d'un fonctionnement sans défaut et **en ce que**, si une surintensité est détectée, il en est conclu qu'un court-circuit de bornes se produit entre les phases du moteur.
